# EUROPÄISCHE PATENTSCHRIFT

(11) **EP 0 967 296 B1**
(45) Veröffentlichungstag und Bekanntmachung des Hinweises auf die Patenterteilung: **10.12.2003**
(21) Anmeldenummer: 99111633.6
(22) Anmeldetag: 16.06.1999
(51) Int. Cl.: C23C 14/02, C23C 14/58, H01L 21/00, H01L 21/768, H01L 21/3205

(54) **Verfahren zum Beschichten eines Substrats**
Method for coating a substrate
Procédé pour le revêtement d'un substrat

(30) Priorität: 27.06.1998 DE 19828846
(43) Veröffentlichungstag der Anmeldung: 29.12.1999
(73) Patentinhaber: Micronas GmbH, 79108 Freiburg (DE)
(72) Erfinder: Krumrey, Joachim, 81669 München (DE); Igel, Günter, 79331 Teningen (DE)
(74) Vertreter: Patentanwälte Westphal, Mussgnug & Partner

(56) Entgegenhaltungen:
- DE-A- 19 641 777
- US-A- 5 645 976
- PATENT ABSTRACTS OF JAPAN vol. 007, no. 115 (E-176), 19. Mai 1983 (1983-05-19) -& JP 58 035986 A (FUJI DENKI SOUGOU KENKYUSHO:KK;OTHERS: 01), 2. März 1983 (1983-03-02)
- PATENT ABSTRACTS OF JAPAN vol. 007, no. 115 (E-176), 19. Mai 1983 (1983-05-19) -& JP 58 035985 A (FUJI DENKI SOUGOU KENKYUSHO:KK;OTHERS: 01), 2. März 1983 (1983-03-02)

## Beschreibung

Die vorliegende Erfindung betrifft ein Verfahren zum Beschichten eines Substrats, insbesondere zum Herstellen eines Sensors, wobei an einem Teilbereich der Oberfläche des Substrats wenigstens eine Struktur erzeugt wird, an der eine auf die Oberfläche des Substrats aufzubringende Schicht besser anhaftet als an einem außerhalb der Struktur befindlichen Oberflächenbereich des Substrats, wobei die Schicht nach dem Erzeugen der Struktur auf die Oberfläche des Substrats aufgebracht wird und seitlich über die Struktur überstehende Bereiche der Schicht mechanisch entfernt werden und wobei das Material der Struktur zumindest ein chemisches Element oder eine chemische Verbindung enthält, welche(s) die auf die Struktur aufgebrachte Schicht nicht oder nur in geringerer Konzentration als das Material der Struktur aufweist.

Aus DE 196 41 777 A1 ist bereits bekannt, ein solches Verfahren zum Herstellen eines Sensors mit einer Metallelektrode in einer MOS-Anordnung zu verwenden. Dieses Verfahren hat sich in der Praxis deshalb als vorteilhaft erwiesen, da es eine strukturierte Beschichtung eines Substrats ermöglicht, ohne daß dabei die auf das Substrat aufgebrachte Beschichtung mittels eines photolithographischen Prozesses und/oder eines Ätzprozesses strukturiert werden muß. Eine Kontamination der für die MOS-Halbleiterfertigung verwendeten Fertigungsanlagen durch das auf das Substrat aufzubringende metallische Elektrodenmaterial wird somit vermieden. Eine solche Kontamination kann beispielsweise bei photolithographischen Strukturierungsverfahren beim Ablösen des Fotolacks oder beim Ätzen der zu strukturierenden metallischen Schicht auftreten. Metallische Verunreinigungen der Fertigungsanlagen sind vor allem deshalb unerwünscht, weil sie die Durchschlagfestigkeit von Gate-Oxiden und somit die Zuverlässigkeit der mit den Fertigungsanlagen hergestellten Halbleitern herabsetzen.

Ein Nachteil des vorbekannten Beschichtungsverfahrens besteht jedoch noch darin, daß die Schicht nur mit einer relativ geringen Dicke aufgetragen werden darf, da die seitlich über die Struktur überstehenden Bereichen der Schicht anderenfalls nicht mit mechanischen Mitteln entfernt werden können. Die nach dem eingangs genannten Verfahren hergestellten Schichten weisen deshalb nur eine vergleichsweise geringe Temperaturbeständigkeit auf, das heißt die in dem strukturierten Bereich des Substrats befindlichen chemischen Verbindungen oder Elemente, wie zum Beispiel Silizium, können aus dem Substrat in die darauf aufgebrachte Schicht diffundieren und gegebenenfalls bis an die Oberfläche dieser Schicht gelangen. Dabei ist es sogar möglich, daß die aus dem Substrat in die Schicht diffundierten Substanzen eine chemische Verbindung mit in der Schicht enthaltenen Stoffen eingehen und/oder sich mit diesen vermischen und deren chemische und/oder physikalische Eigenschaften, wie beispielsweise die Korrosionsbeständigkeit, verändern. Eine solche unerwünschte Diffusion von Stoffen aus dem Substrat in die darauf, aufgebrachte Schicht tritt insbesondere bei höheren Temperaturen auf, zum Beispiel bei über 100°C. Solche Temperaturen sind jedoch in der Halbleiterfertigung unvermeidbar und können beispielsweise bei einer Temperaturbehandlung zum Aushärten auf einer auf dem Substrat befindlichen Lackschicht oder beim Anbringen einer Bond-Verbindung an dem Substrat auftreten.

US 5 645 976 beschreibt ein Verfahren zur Herstellung eines Kondensators bei dem auf einer SiO₂-Schicht Strukturen eines anderen Materials, z.B. von PbZrO₃, gebildet werden. Anschliessend wird eine Pd- oder Pt-Schicht und folgend weitere Schichten ganzflächig abgeschieden. Diese Schichten können mittels einer Ultraschallbehandlung in den Bereichen entfernt werden in denen sie auf dem SiO₂-Schicht aufliegen.

In JP 58 035 986 werden in einem Verfahren zur Herstellung einer Schottky-Diode auf eine durch Fenster zum darunterliegenden Si-Substrat unterbrochene SiO₂-Schicht zuerst eine Pd- oder Pt-Schicht und dann weitere Schichten abgeschieden. Die Schichten werden in den Bereichen mittels Ultraschall entfernt, in denen sie auf SiO₂ aufliegen. Auf der so erhaltenen Struktur wird eine weitere Schicht abgeschieden, die mit Phototechnik und Ätzen strukturiert wi rd.

In JP 58 035 985 wird ebenfalls ein Verfahren zur Herstellung einer Schottky-Diode beschrieben bei denen eine Schicht mit Ultraschall von den Bereichen entfernt wird bei denen sie in Kontakt mit einer SiO₂-Schicht ist. Die folgenden Schichten werden wieder mittels Phototechnik und Ätzen stukuriert.

Es besteht deshalb die Aufgabe, ein Verfahren zur Herstellung einer ausreichend dicken Schicht auf dem Substrat zu schaffen beider eine Diffusion von Stoffen aus dem Substrat in oberflächennahe Bereiche der Schicht ausgeschlossen oder zumindest erheblich reduziert ist.

Die Lösung dieser Aufgabe besteht in einen kombination von technischen Elementen gemäß Anspruch 1.

Es wird also auf die bereits strukturierte erste Schicht eine zweite, mit dieser verbundenen Schicht aufgebracht, welche die gleiche Struktur aufweist wie die erste Schicht. Dadurch wird einerseits eine größere Schichtdicke erreicht, so daß die in dem Substrat befindlichen chemischen Elemente oder Verbindungen einen größeren Weg zurücklegen müssen, um an die Oberfläche der obersten Schicht zu gelangen und andererseits wird aber auch zwischen der ersten und der zweiten Schicht eine Grenzfläche geschaffen, die das Hindurchdiffundieren von Stoffen aus dem Substrat in die zweite Schicht erschwert. Das erfindungsgemäße Verfahren ermöglicht somit ohne die Verwendung von Photolithographie- oder Ätzprozessen und somit unter Vermeidung einer Kreuzkontamination der für die Herstellung eines Sensors verwendeten Fertigungsanlagen mit in der Beschichtung enthaltenen chemischen Elementen oder Verbindungen das Aufbringen einer strukturierten Schicht auf einen Teilbereich der Oberfläche eines Substrats, wobei die Schicht zumindest in einem oberflächennahen Bereich in ihrer chemischen Zusammensetzung und ihren physikalischen Eigenschaften weitestgehend stabil gegenüber den bei einer Temperaturbehandlung auftretenden Temperaturen ist. Gegebenenfalls kann auf diese Schicht wenigstens eine weitere Schicht aufgebracht werden.

Eine Ausführungsform der Erfindung sieht vor, daß die seitlich über die Struktur überstehenden Bereiche der ersten Schicht vor dem Auftragen der zweiten Schicht insbesondere mittels Ultraschall entfernt werden. Die zweite Schicht wird also in einem späteren Fertigungsschritt aufgetragen als die erste Schicht, so daß chemische Elemente oder Verbindungen, die während einer zwischen dem Auftragen der ersten und der zweiten Schicht stattfindenden Temperaturbehandlung aus dem Substrat in die erste Schicht diffundieren, zunächst nicht über die Oberfläche der ersten Schicht hinausgelangen können. Die an der Oberfläche der ersten Schicht erreichte Konzentration der aus dem Substrat diffundierten chemischen Elemente oder Verbindungen, die gegenüber der Konzentration dieser Elemente oder Verbindungen in dem Substrat geringer ist, bildet dann nach dem Auftragen der zweiten Schicht den Ausgangspunkt für eine eventuelle weitere Diffusion dieser Elemente oder Verbindungen an die Oberfläche dieser Schicht, so daß die Elemente oder Verbindungen dorthin nur mit einer entsprechend geringeren Konzentration gelangen können.

Die seitlich über die Struktur überstehenden Bereiche der ersten Schicht werden vorzugsweise mittels Ultraschall entfernt, wobei durch die im Vergleich zu der unstrukturierten Substrat-Oberfläche besseren Hafteigenschaften der Struktur erreicht wird, daß die erste Schicht nur an der Struktur haften bleibt, während sich über die Struktur überstehende Bereiche dieser Schicht von dem Substrat ablösen. Die überstehenden Bereiche der ersten Schicht können aber auch mit anderen mechanischen Bearbeitungsverfahren, beispielsweise durch Bürsten entfernt werden.

Vorteilhaft ist, wenn die zweite Schicht durch galvanisches oder außenstromloses Abscheiden eines Metalls, insbesondere eines Edelmetalls auf die elektrisch leitfähige erste Schicht aufgebracht wird. Dabei erfolgt das Abscheiden des Metalls vorzugsweise außenstromlos.

Eine bevorzugte Ausführungsform der Erfindung sieht vor, daß die zweite Schicht auf die Oberfläche des Substrats aufgebracht wird nachdem die seitlich über die Struktur überstehenden Bereiche der ersten Schicht entfernt wurden, daß die Hafteigenschaften der zweiten Schicht so gewählt werden, daß sie an der ersten Schicht besser anhaftet als an einem die erste Schicht nicht aufweisenden Oberflächenbereich des Substrats und daß nach dem Auftragen der zweiten Schicht seitlich über die erste Schicht überstehende Bereiche der zweiten Schicht mechanisch entfernt werden, insbesondere mittels Ultraschall. Dabei können die Hafteigenschaften der zweiten Schicht durch eine entsprechende Gestaltung der Oberfläche der ersten Schicht, beispielsweise eine Mikrorauhigkeit und/oder durch eine chemische Eigenschaft der Schicht, wie beispielsweise das Vorhandensein ungesättigter chemischer Bindungen, erreicht werden. Überraschenderweise ist es also möglich, durch entsprechende Wahl der Hafteigenschaften der ersten Schicht auf diese Schicht eine zweite Schicht aufzubringen und diese ebenfalls durch mechanisches Entfernen ihrer seitlich über die Struktur beziehungsweise den Rand der ersten Schicht überstehenden Bereiche zu strukturieren. Somit kann insgesamt eine Beschichtung mit vergleichsweise großer Dicke erzeugt werden und dennoch lassen sich die über die Struktur überstehenden Bereiche von dem Substrat entfernen, ohne daß gleichzeitig auch die auf der Struktur befindlichen Bereiche der Beschichtung von dem Substrat abgelöst werden.

Gemäß einer anderen, vorteilhaften Ausführungsform der Erfindung ist vorgesehen, daß zunächst die erste Schicht und dann auf diese die zweite Schicht sowie gegebenenfalls darauf wenigstens eine weitere Schicht aufgebracht werden, und daß danach die seitlich über die Struktur überstehenden Bereiche dieser Schichten gleichzeitig mechanisch entfernt werden, insbesondere mittels Ultraschall. Dabei ist es sogar möglich, daß für die zweite und/oder andere mittelbar oder unmittelbar auf diese aufgebrachte Schichten Materialien verwendet werden, die an der Struktur etwa genauso gut oder sogar schlechter anhafteten als an einem außerhalb der Struktur befindlichen Oberflächenbereich des Substrats und daß die aus diesen Materialien bestehenden Schichten durch die Vermittlung der ersten, unmittelbar auf die Substrat-Oberfläche aufgebrachten Schicht strukturiert werden. Auf diese Weise können sogar andere Schichten, die sich mit anderen Verfahren nicht oder nur schlecht strukturieren lassen, auf einfache Weise durch die Vermittlung der ersten Schicht strukturiert werden. Dabei weist die erste Schicht einen größeren Unterschied zwischen dem Haftvermögen an der Struktur und demjenigen an einem die Struktur nicht aufweisenden Oberflächenbereich des Substrats auf, als die anderen Schichten auf der ersten Schicht. Bei den anderen, vermittelnd zu strukturierten Schichten kommt es also nicht auf einen Haftungsunterschied an, sondern es ist ausreichend, wenn diese genügend gut an der ersten Schicht anhaften. Somit können durch entsprechende Wahl der Hafteigenschaften der ersten Schicht andere, praktisch jedem beliebigen Material bestehende Schichten strukturiert werden.

Besonders vorteilhaft ist, wenn die zweite Schicht und/oder wenigstens eine mittelbar oder unmittelbar darauf aufgebrachte weitere Schicht mit einer geringeren Dicke aufgetragen werden als die erste Schicht. Dadurch kann die zweite Schicht und/oder die darauf aufgebrachten weiteren Schichten durch die Vermittlung der ersten Schicht besser strukturiert werden. Insbesondere lassen sich seitlich über die an der Oberfläche des Substrats befindliche Struktur überstehende Bereiche der zweiten Schicht oder der weiteren Schichten leichter mechanisch entfernen.

Besonders vorteilhaft ist, wenn die erste und/oder zweite Schicht und/oder wenigstens eine weitere, auf die zweite Schicht aufgebrachte Schicht vor dem Entfernen der über die Struktur überstehenden Bereiche durch Einbringen von Fremdatomen mechanisch verspannt wird (werden). Die seitlich über die Struktur überstehende Überstände lassen sich dann leichter, beispielsweise mittels Ultraschall entfernen. Die Schicht kann beispielsweise zum Einbringen von Wasserstoffatomen einer wasserstoffhaltigen Athmosphäre ausgesetzt werden. Eine andere Möglichkeit Fremdatome einzubringen besteht darin, daß in die Schicht Ionen oder dergleichen Teilchen implantiert wird.

Gemäß einer Ausführungsform der Erfindung ist vorgesehen, daß für die erste und die zweite Schicht und gegebenenfalls wenigstens eine weitere, auf die zweite Schicht aufgebrachte Schicht das gleiche Material verwendet wird. Das Verfahren ist dann besonders einfach durchführbar. So kann beispielsweise auf eine auf einer Struktur aus Poly-Silizium angeordneten Metallschicht eine Schicht aus dem gleichen Metall aufgebracht werden, um einer Silizidbildung an der Oberfläche des Metalls entgegenzuwirken.

Eine andere Ausführungsform sieht vor, daß für unterschiedliche Schichten unterschiedliche Materialien verwendet werden. Dabei können für diese Schichten gegebenenfalls artgleiche Materialien, wie beispielsweise unterschiedliche Metalle verwendet werden. So kann beispielsweise auf eine Schicht aus Palladium eine weitere Schicht aus Iridium aufgetragen werden. Gegebenenfalls kann für die unmittelbar auf die Oberfläche des Substrats aufgebrachte Schicht auch ein kostengünstiges Material verwendet werden, das dann mit einem teureren Material beschichtet wird. Dabei kann das kostengünstigere Material als Diffusionssperre für in dem Substrat befindliche chemische Elemente oder Substanzen dienen.

Nachfolgend sind Ausführungsbeispiele der Erfindung anhand der Zeichnung näher erläutert.

Es zeigen:
- Fig.1: einen Teilquerschnitt durch ein Substrat, das an seiner Oberfläche eine Siliziumoxid-Schicht mit einer darauf befindlichen Struktur aufweist,
- Fig.2: die in Figur 1 gezeigte Anordnung, nach dem Aufbringen einer Palladium-Schicht,
- Fig.3: die in Figur 2 gezeigte Anordnung, nach dem Entfernen der mit der Siliziumoxid-Schicht verbundenen Bereiche der Palladium-Schicht,
- Fig.4: die in Figur 3 gezeigte Anordnung, nach einer Temperatur-behandlung,
- Fig.5: die in Figur 4 gezeigte Anordnung nach dem Aufbringen einer weiteren Palladium-Schicht,
- Fig.6: den in Figur 5 gezeigten Körper nach dem Entfernen seitlich über die Palladiumsilizid-Schicht überstehender Bereiche der Palladium-Schicht,
- Fig.7: eine Darstellung ähnlich Figur 5, wobei jedoch zusätzlich noch eine Iridium-Schicht auf die Palladium-Schicht aufgetragen wurde,
- Fig.8: den in Figur 7 gezeigten Körper nach dem Entfernen seitlich über die Struktur überstehender Bereiche der Palladium- und der Iridium-Schicht,
- Fig.9: eine Tiefenprofilanalyse, bei der von der Beschichtung des in Figur 4 gezeigten Sensors durch Sputtern Beschichtungsmaterial abgetragenen wurde, wobei auf der Abszisse die Abtragungsdauer und auf der Ordinate die Konzentration der in dem jeweils abgetragenen Beschichtungsmaterial enthaltenen Bestandteile aufgetragen ist und
- Fig.10: eine entsprechende Tiefenprofilanalyse für den Sensor nach Figur 6.

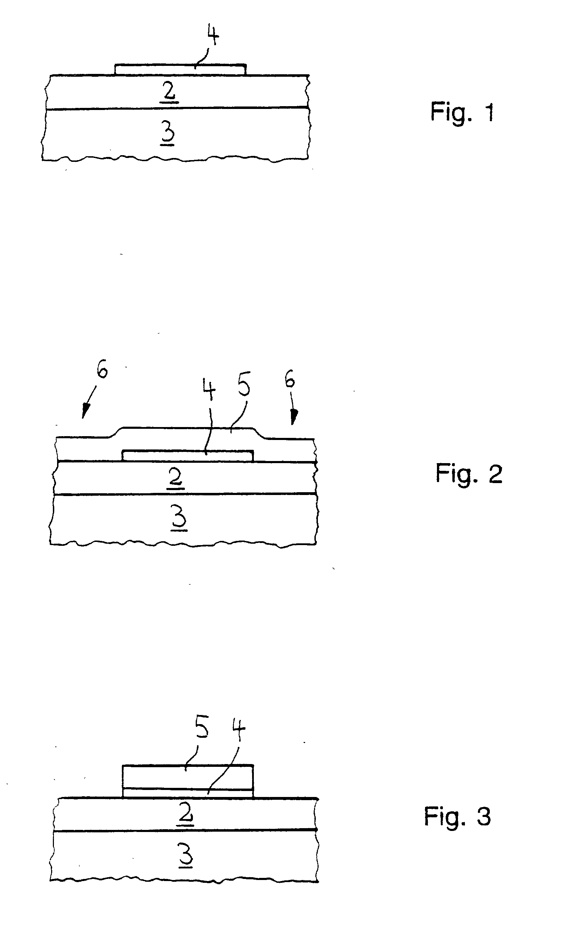

Bei einem Verfahren zum Herstellen eines Sensors 1 wird auf einen Teilbereich der Oberfläche einer Siliziumoxid-Schicht 2 eines einen Grundkörper 3 aus Silizium aufweisenden Substrats mittels Maskentechnik eine Struktur 4 aus Polysilizium aufgebracht (Figur 1). Die Hafteigenschaften der Struktur 4 sind so gewählt, daß eine darauf aufzubringende, aus Palladium bestehende erste Schicht 5 an der Struktur 4 besser anhaftet als an der Oberfläche der Siliziumoxid-Schicht 2. Nach dem Aufbringen der Struktur 4 wird auf die Oberfläche des Substrats und der Struktur 4 ganzflächig die erste Schicht 5 aus Palladium aufgetragen (Figur 2). Dies kann beispielsweise in der Weise geschehen, daß das Substrat zusammen mit einem Palladium-Schmelztiegel im Vakuum angeordnet wird, so daß aus dem Palladium ausgetretene Dämpfe an dem Substrat kondensieren. Eine andere Möglichkeit der Beschichtung besteht darin, daß die Palladium-Schicht 5 durch Sputtern aufgetragen wird. Dabei wird ein Palladium-Target mit einem energiereichen Strahl beschossen, wobei aus dem Target Palladium austritt, welches das Substrat beschichtet.

Nach dem Aufbringen der ersten Schicht 5 werden die außerhalb der Struktur 4 befindlichen seitlich über diese überstehenden Bereiche 6 der Schicht 5 mechanisch entfernt. Dazu kann die erste Schicht 5 beispielsweise ganzflächig gebürstet werden, wobei sich die mit der Siliziumoxid-Schicht 2 unmittelbar verbundenen Bereiche 6 der Schicht 5 wegen der dort nur geringen Haftung von der Siliziumoxid-Schicht 2 ablösen, während die mit der Struktur 4 verbundenen Bereiche der Schicht 5 aufgrund der besseren Hafteigenschaften der Struktur 4 an dieser haften bleiben.

Eine andere Möglichkeit, die seitlich über die Struktur überstehenden Bereiche 6 der Schicht 5 zu entfernen, besteht darin, daß die Schicht 5 einer Ultraschallbehandlung unterzogen wird, bei der nur die auf der Struktur 4 angeordneten Bereiche der Schicht 5 haften bleiben, während sich die übrigen, mit der Siliziumoxid-Schicht 2 verbundenen Bereiche 6 der Schicht 5 von dem Substrat ablösen. Insgesamt ergibt sich somit der in Figur 3 gezeigte Körper, der auf einer Siliziumoxid-Schicht 2 eine strukturierte Polylsilizium-Schicht 4 und auf dieser eine Palladium-Schicht 5 aufweist, die entsprechend der Struktur 4 strukturiert ist.

Im Verlauf eines weiteren Fertigungsschrittes wird das in Figur 3 gezeigte Substrat einer Temperaturbehandlung unterzogen, bei welcher das Substrat etwa 1 Stunde lang einer Temperatur von 250°C ausgesetzt wird. solche Temperaturbehandlung kann beispielsweise zum Entfernen einer auf die Oberfläche des Substrats aufgebrachten Fotolackschicht vorgesehen sein. Entsprechende Temperaturen können aber auch beim Anbringen einer Bond-Verbindung an dem Substrat auftreten.

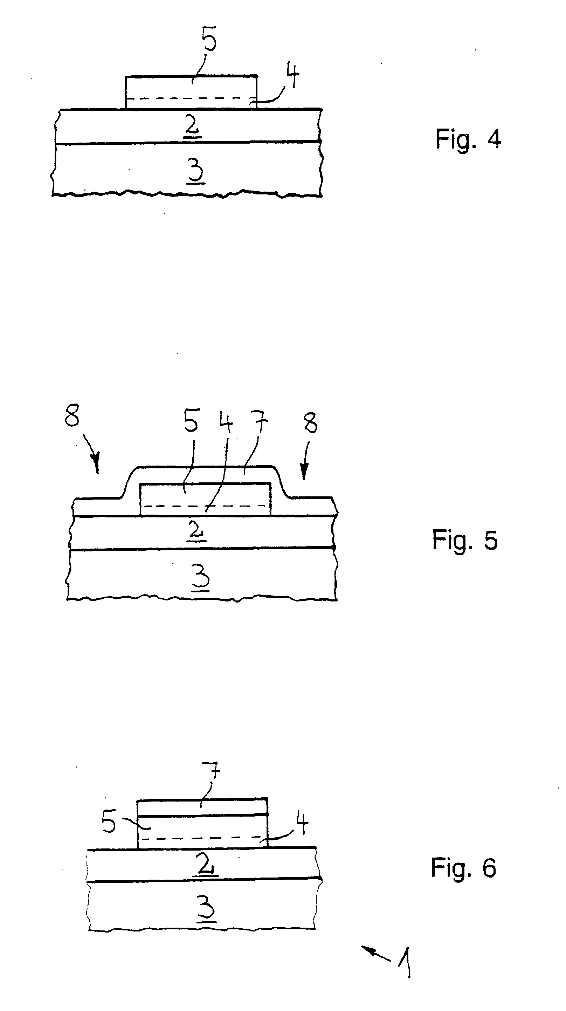

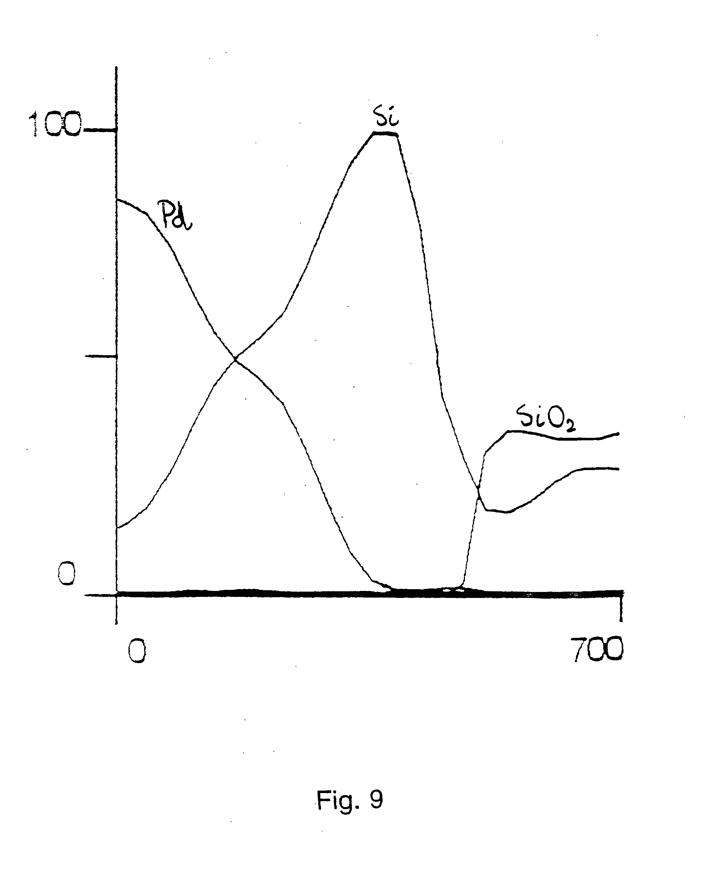

Figur 9 zeigt eine Tiefenprofilanalyse der Schicht 5 und der Struktur 4. Dabei wurde im Bereich der auf der Struktur 4 befindlichen Schicht 5 über einen Zeitraum von etwa 700 Sekunden durch Sputtern Material an der Oberfläche des Substrats abgetragen, wobei jeweils die Konzentrationen der abgetragenen Stoffe ermittelt wurden. Deutlich ist erkennbar, daß einerseits Silizium aus der aus Polysilizium bestehenden Struktur 4 bis an die Oberfläche der Palladium-Schicht diffundiert ist und daß andererseits aber auch das Palladium aus der Schicht 5 in die Struktur 4 diffundiert ist. Während der Temperaturbehandlung findet also eine Interdiffusion des in der Schicht 5 enthaltenen Palladiums und des Siliziums statt, wobei sich anschließend Palladiumsilizid bildet, das eine geringere Korrosionsbeständigkeit als metallisches Palladium aufweist. Um zu verdeutlichen, daß die Struktur 4 und die Schicht 5 ineinander diffundiert sind, ist die Grenzfläche zwischen der Struktur 4 und der Schicht 5 in den Figuren 4 bis 8 jeweils strichliniert dargestellt.

Auf die Oberfläche des Substrats wird nun eine zweite Schicht 7 aus metallischem Palladium aufgebracht, welche die erste Schicht 5 sowie die freiliegenden Oberflächenbereiche der Siliziumoxid-Schicht 2 abdeckt und jeweils mit der Schicht 5 beziehungsweise der Siliziumoxid-Schicht 2 verbunden ist. Die zweite Schicht 7 kann in gleicher Weise wie die erste Schicht 5 aufgetragen werden, beispielsweise durch Bedampfen oder Sputtern. Die Hafteigenschaften der zweiten Schicht 7 sind so gewählt, daß die zweite Schicht 7 an der ersten Schicht 5 besser anhaftet, als an der Siliziumoxid-Schicht 2. Dadurch ist es möglich, die zweite Schicht 7 in gleicher Weise zu strukturieren wie die erste Schicht, nämlich durch mechanisches Entfernen der seitlich über die erste Schicht 5 beziehungsweise die Struktur 4 überstehenden, mit der Siliziumoxid-Schicht 2 verbundenen Bereiche 8. Das Entfernen der Bereiche 8 der Schicht 7 kann beispielsweise durch Bürsten oder mittels Ultraschall erfolgen, wobei die mit dem Siliziumoxid 2 verbundenen Bereiche 8 von dem Substrat abgelöst werden, während die mit der ersten Schicht 5 verbundenen Bereiche der zweiten Schicht 7 an der ersten Schicht haften bleiben.

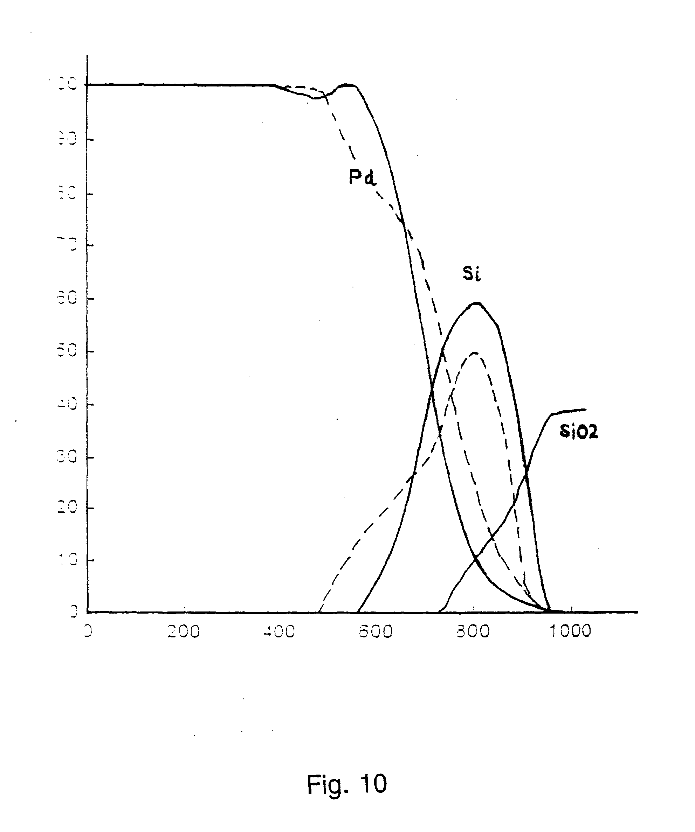

Figur 10 zeigt eine Tiefenprofilanalyse des nach dem beschriebenen Verfahren hergestellten, in Figur 6 gezeigten Sensors 1 im Bereich der Schichtenfolge 2, 4, 5, 7. Dabei ist jeweils der Konzentrationsverlauf des Palladiums und des Siliziums unmittelbar nach dem Aufbringen der zweiten Schicht 7 durch eine durchgezogene Linie markiert. Zusätzlich sind die entsprechenden Konzentrationsverläufe nach einer einstündigen Temperung des Sensors 1 bei 250°C strichliniert in dem Diagramm eingetragen. Deutlich ist zu erkennen, daß das Silizium bei der Temperung nur in einem vergleichsweise schmalen und von der Oberfläche der zweiten Palladium-Schicht 7 (in Figur 9 links) relativ weit beabstandeten Bereich in die beiden das Palladium aufweisenden Schichten 4, 5 und 7 diffundiert ist und daß nach der Temperung an der Oberfläche der obersten Schicht 7 ein ausreichend breiter Bereich mit einer Palladium-Konzentration von etwa 100 % verbleibt. Die chemischen und physikalischen Eigenschaften im oberflächennahen Bereich des durch die beiden Schichten 5 und 7 gebildeten Palladiumkontakts des Sensors 1 sind also weitgehend stabil gegenüber Temperaturprozessen.

Wie aus einem Vergleich von Figur 9 mit Figur 10 erkennbar ist, kann durch das Aufbringen einer zweiten Palladium-Schicht 7 auf die bereits vorhandene Palladium-Schicht 5 die Palladiumsilizid-Konzentration an der Oberfläche des Sensors 1 von etwa 15 % auf nahezu Null gesenkt werden, wodurch sich insbesondere auch die Korrosionsbeständigkeit der Palladium-Schicht 7 verbessert. Mit dem vorstehend beschriebenen Verfahren kann ein Substrat mit einer strukturierten Metallschicht beschichtet werden, ohne daß das Aufbringen einer Fotomaske oder einer Hilfsmaske auf die Metallschicht und/oder ein Ätzen der Metallschicht erforderlich ist. Somit wird eine Kreuzkontamination der Fertigungsanlagen durch das Metall vermieden. Das Verfahren eignet sich deshalb besonders zur Herstellung von MOS-Halbleiterschaltungen.

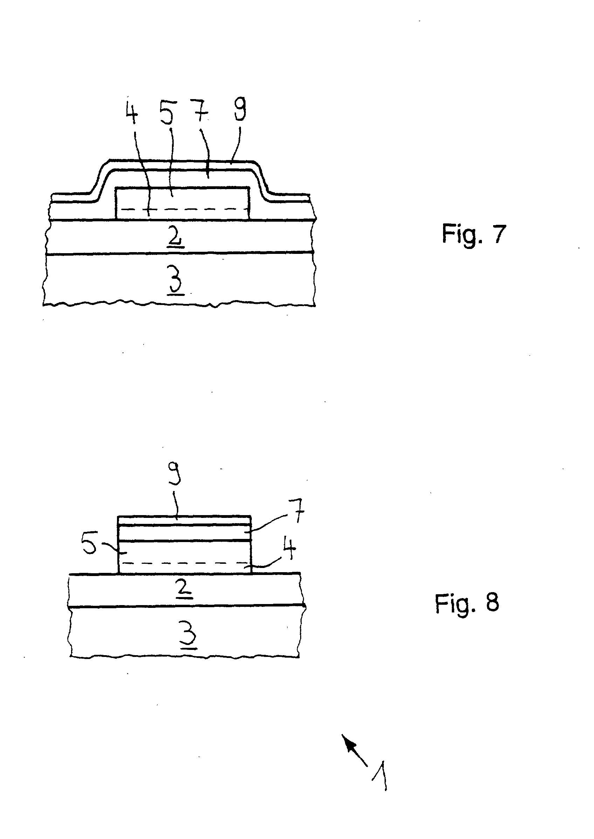

Bei dem Ausführungsbeispiel nach Figur 7 wird auf die zweite Palladium-Schicht 7 der Anordnung gemäß Figur 5 noch eine dritte metallische Schicht aus Iridium aufgebracht, die mit der Palladium-Schicht 7 verbunden ist und an dieser anhaftet. Danach werden die seitlich über die Struktur 4 überstehenden Bereiche der Schichten 7 und 9 gleichzeitig mechanisch entfernt. Dies kann beispielsweise durch Bürsten der Iridium-Schicht 9 oder durch Anwendung von Ultraschall erfolgen. Dabei löst sich die Palladium-Schicht 5 in den Bereichen, in denen sie mit der Siliziumoxid-Schicht 2 verbunden ist von dieser ab, wobei dann gleichzeitig auch die auf diesen Bereichen der Schicht 7 befindliche Iridium-Schicht 9 von dem Substrat entfernt wird. Die mit der ersten Palladium-Schicht 5 verbundenen Bereiche der zweiten Palladium-Schicht 7 bleiben jedoch zusammen mit den an diesen Bereichen fixierten Teilbereichen der Iridium-Schicht 9 an der Palladium-Schicht 5 haften. Die Iridium-Schicht 9 wird also durch die zweite Palladium-Schicht 7 vermittelnd strukturiert und weist nach dem Entfernen der über die Struktur 4 seitlich überstehenden Bereiche 6 eine der Struktur 4 entsprechende Struktur auf (Figur 8).

Somit kann die Iridium-Schicht, die mit anderen Verfahren, wie beispielsweise durch Ätzen nur schlecht strukturierbar ist, auf einfache Weise strukturiert werden.

Die mit der Iridium-Schicht 9 verbundene zweite Palladium-Schicht 7 und die zwischen diesen Schichten befindliche Grenzfläche wirken als Diffusionssperre für in der Struktur 4 und der ersten Palladium-Schicht 5 befindliches Silizium. Dadurch wird die Bildung von Iridiumsilizid weitestgehend verhindert. Auch wird eine Kontamination der Fertigungsanlagen mit Palladium und/oder Iridium vermieden.

Wie aus Figur 7 und 8 erkennbar ist, wird die Iridium-Schicht 9 mit einer geringeren Dicke auf das Substrat aufgebracht als die Palladium-Schicht 5. Die seitlich über die Struktur 4 überstehenden Bereiche der Schichten 7 und 9 lassen sich dadurch besser entfernen.

Erwähnt werden soll noch, daß bei den beiden vorstehend beschriebenen Ausführungsbeispielen jeweils vor dem Entfernen der über die Struktur 4 seitlich überstehenden Bereiche 8 der zweiten Palladium-Schicht 7 und/oder der Iridium-Schicht 9 diese Schicht(en) 7, 9 durch Inkorporation von Fremdatomen verspannt werden können. Die seitlich über die Struktur 4 überstehenden Bereiche 8 dieser Schichten 7, 9 lassen sich dann leichter mechanisch entfernen.

Die Fremdatome können beispielsweise dadurch in die Palladium-Schicht 7 und/oder die Iridiumschicht 9 eingebracht werden, daß die Oberfläche der Palladium-Schicht 7 oder der Iridium-Schicht 9 einer Wasserstoff-Atmosphäre ausgesetzt wird. Eine andere Möglichkeit die Fremdatome in die Schicht(en) 7, 9 einzubringen besteht darin, diese Schicht(en) 7, 9 mit Ionen zu beschießen, die sich dann in der (den) Schicht(en) 7, 9 einlagern. Die Fremdatome können aber auch in die Struktur 4 und/oder den Grundkörper (3) integriert werden, so daß sie nach dem Auftragen der Schicht(en) - gegebenenfalls unter Einwirkung von Wärme - in diese Schicht(en) 7, 9 diffundieren können.

Zusammenfassend wird festgestellt: Bei einem Verfahren zum Beschichten eines Substrats wird in einem Teilbereich dessen Oberfläche eine Struktur 4 erzeugt, an der eine auf der Oberfläche des Substrats aufzubringende erste Schicht 5 besser anhaftet als an einem außerhalb der Struktur 4 befindlichen Oberflächenbereich des Substrats. Anschließend wird die Schicht 5 auf der Oberfläche des Substrats aufgebracht und danach werden seitlich über die Struktur 4 überstehende Bereiche der Schicht mechanisch entfernt. Das Material der Struktur 4 enthält zumindest ein chemisches Element oder eine Verbindung, welche(s) die Schicht 5 nicht oder nur in geringerer Konzentration als das Material der Struktur 4 aufweist. Auf die erste Schicht 5 wird dann zumindest eine zweite Schicht 7 aufgebracht, die das in dem Material der Struktur 4 enthaltene chemische Element oder die Verbindung nicht oder nur in geringerer Konzentration als das Material der Struktur 4 aufweist. Das Verfahren ermöglicht es, auf eine Substrat eine strukturierte Schicht aufzubringen, deren Oberflächeneingenschaften bei einer Temperung weitgehend unverändert bleiben.

## Patentansprüche

1. Verfahren zum Beschichten eines Substrats, insbesondere zum Herstellen eines Sensors (1), wobei an einem Teilbereich der Oberfläche des Substrats wenigstens eine Struktur (4) erzeugt wird, an der eine auf die Oberfläche des Substrats aufzubringende Schicht (5) besser anhaftet als an einem außerhalb der Struktur (4) befindlichen Oberflächenbereich des Substrats, wobei die Schicht (5) nach dem Erzeugen der Struktur (4) auf die Oberfläche des Substrats aufgebracht wird und seitlich über die Struktur (4) überstehende Bereiche der Schicht (5) mechanisch entfernt werden, wobei das Material der Struktur zumindest ein chemisches Element oder eine chemische Verbindung enthält, welche(s) die auf die Struktur (4) aufgebrachte Schicht (5) nicht oder nur in geringerer Konzentration als das Material der Struktur (4) aufweist, und daß auf die auf die Oberfläche aufgebrachte erste Schicht (5) zumindest eine zweite Schicht (7) aufgebracht wird, und daß die zweite Schicht (7) das in dem Material der Struktur (4) enthaltene chemische Element oder die chemische Verbindung nicht oder nur in geringerer Konzentration als das Material der Struktur (4) aufweist, wobei die seitlich über die Struktur (4) überstehenden Bereiche der ersten Schicht (5) vor dem Auftragen der zweiten Schicht (7) entfernt werden und wobei die Hafteigenschaften der zweiten Schicht (7) so gewählt werden, das sie an der ersten Schicht (5) besser anhaftet als an einem die erste Schicht (5) nicht aufweisenden Oberflächenbereicht des Substrats, **dadurch gekennzeichnet, daß** nach dem Auftragen der zweiten Schicht (7) seitlich über die erste Schicht (5) überstehende Bereiche der zweiten Schicht (7) mechanisch entfernt werden.

2. Verfahren nach Anspruch 1, **dadurch gekennzeichnet, daß** die seitlich über die Struktur (4) überstehenden Bereiche der ersten Schicht (5) vor dem Auftragen der zweiten Schicht (7) mittels Ultraschall entfernt werden.

3. Verfahren nach Anspruch 1 oder 2, **dadurch gekennzeichnet, daß** die zweite Schicht (7) durch galvanisches oder außenstromloses Abscheiden eines Metalls, insbesondere eines Edelmetalls, auf die elektrisch leitfähige erste Schicht (5) aufgebracht werden.

4. Verfahren nach einem der Ansprüche 1 bis 3, **dadurch gekennzeichnet, daß** nach dem Auftragen der zweiten Schicht (7) seitlich über die erste Schicht (5) überstehende Bereiche der zweiten Schicht (7) mechanisch mittels Ultraschall entfernt werden.

5. Verfahren nach einem der Ansprüche 1 bis 4, **dadurch gekennzeichnet, daß** die zweite Schicht (7) und/oder wenigstens eine mittelbar oder unmittelbar darauf aufgebrachte weitere Schicht (9) mit einer geringeren Dicke aufgetragen werden als die erste Schicht (5).

6. Verfahren nach einem der Ansprüche 1 bis 5, **dadurch gekennzeichnet, daß** die erste Schicht (5) und/oder zweite Schicht (7) und/oder wenigstens eine weitere, auf die zweite Schicht (7) aufgebrachte Schicht (9) vor dem Entfernen ihrer seitlich über die Struktur (4) überstehenden Bereiche durch Einbringen von Fremdatomen mechanisch verspannt wird (werden).

7. Verfahren nach einem der Ansprüche 1 bis 6, **dadurch gekennzeichnet, daß** für die erste Schicht (5) und die zweite Schicht (7) und gegebenenfalls wenigstens eine weitere, auf die zweite Schicht (7) aufgebrachte Schicht (9) das gleiche Material verwendet wird.

8. Verfahren nach einem der Ansprüche 1 bis 6, **dadurch gekennzeichnet, daß** für unterschiedliche Schichten (5, 7, 9) unterschiedliche Materialien verwendet werden.

9. Verfahren nach einem der Ansprüche 1 bis 8, **dadurch gekennzeichnet, daß** zumindest als oberste Schicht wenigstens eine Edelmetallschicht aufgetragen wird.

## Claims

1. A method for coating a substrate, in particular for manufacturing a sensor (1), whereby at a sub-region of the surface of the substrate at least one structure (4) is produced, to which a layer (5) to be applied to the surface of the substrate adheres better than to a surface region of the substrate situated outside the structure (4), whereby the layer (5) is applied to the surface of the substrate after the production of the structure (4) and regions of the layer (5) that laterally project over the structure (4) are mechanically removed, whereby the material of the structure contains at least one chemical element or a chemical compound which does not comprise the layer (5) applied to the structure (4) or only in a smaller concentration than the material of the structure (4), and at least a second layer (7) is applied to the first layer (5) applied to the surface, and the second layer (7) does not comprise the chemical element or the chemical compound contained in the material of the structure (4) or only in smaller concentrations than the material of the structure (4), whereby the regions of the first layer (5) which laterally protrude over the structure are removed prior to the application of the second layer (7) and whereby the adhesion properties of the second layer (7) are chosen so that it adheres better to the first layer (5) than to a surface region of the substrate not having the first layer (5),
**characterised in that** after the application of the second layer (7) regions of the second layer (7) which laterally protrude over the first layer (5) are mechanically removed.

2. A method according to Claim 1,
**characterised in that** regions of the first layer (5) which protrude laterally over the structure (4) are removed by means of ultrasound prior to the application of the second layer (7).

3. A method according to Claim 1 or 2,
**characterised in that** the second layer (7) are applied by electrodeposition or electroless deposition of a metal, in particular a precious metal, onto the electrically conductive first layer (5).

4. A method according to one of Claims 1 to 3,
**characterised in that** after the application of the second layer (7), regions of the second layer (7) laterally protruding over the first layer (5) are mechanically removed by means of ultrasound.

5. A method according to one of Claims 1 to 4,
**characterised in that** the second layer (7) and/or at least a further layer (9) applied directly thereto are applied with a lesser thickness than the first layer (5).

6. A method according to one of Claims 1 to 5,
**characterised in that** the first layer (5) and/or second layer (7) and/or at least a further layer (9) applied to the second layer is (are) mechanically braced by the introduction of foreign atoms prior to the removal of their regions laterally protruding over the structure (4).

7. A method according to one of Claims 1 to 6,
**characterised in that** the same material is used for the first layer (5) and the second layer (7) and possibly at least one further layer (9) applied to the second layer (7).

8. A method according to one of Claims 1 to 6,
**characterised in that** different materials are used for different layers (5, 7, 9).

9. A method according to one of Claims 1 to 8,
**characterised in that** at least one precious metal layer is applied at least as the topmost layer.

## Revendications

1. Procédé pour revêtir un substrat, en particulier pour la production d'un capteur (1), dans lequel, sur une région partielle de la surface du substrat, on produit au moins une structure (4) à laquelle une couche (5) qui doit être déposée sur la surface du substrat adhère mieux qu'à une région de surface du substrat qui se trouve en dehors de la structure (4), la couche (5) étant déposée sur la surface du substrat après la production de la structure (4) et les régions de la couche (5) qui débordent latéralement au-delà de la structure (4) étant enlevées mécaniquement, la matière de la structure contenant au moins un élément chimique ou un composé chimique que la couche (5) déposée sur la structure (4) ne contient pas ou ne contient que dans une plus faible concentration que la matière de la structure (4), au moins une deuxième couche (7) étant déposée sur la première couche (5) déposée sur la surface et la deuxième couche (7) ne contenant pas l'élément chimique ou le composé chimique contenu dans la matière de la structure (4), ou ne le contenant que dans une plus faible concentration que la matière de la structure (4), les régions de la première couche (5) qui débordent latéralement au-delà de la structure (4) étant enlevées avant le dépôt de la deuxième couche (7), et les propriétés d'adhérence de la deuxième couche (7) étant choisies de manière que cette couche adhère mieux à la première couche (5) qu'à une région de surface du substrat qui ne présente pas la première couche (5),
**caractérisé en ce qu'**
après le dépôt de la deuxième couche (7), les régions de la deuxième couche (7) qui débordent latéralement au-delà de la première couche (5) sont enlevées mécaniquement.

2. Procédé selon la revendication 1,
**caractérisé en ce que**
les régions de la première couche (5) qui débordent latéralement au-delà de la structure (4) sont enlevées au moyen d'ultrasons avant le dépôt de la deuxième couche (7).

3. Procédé selon la revendication 1 ou 2,
**caractérisé en ce que**
la deuxième couche (7) est déposée sur la première couche (5) conductrice de l'électricité par le dépôt galvanique ou sans courant extérieur d'un métal, en particulier d'un métal noble.

4. Procédé selon une des revendications 1 à 3,
**caractérisé en ce qu'**
après le dépôt de la deuxième couche (7), les régions de la deuxième couche (7) qui débordent latéralement au-delà de la première couche (5) sont enlevées mécaniquement au moyen d'ultrasons.

5. Procédé selon une des revendications 1 à 4,
**caractérisé en ce que**
la deuxième couche (7) et/ou au moins une autre couche (9), qui est déposée directement ou indirectement sur celle-ci, sont déposées avec une plus faible épaisseur que la première couche (5).

6. Procédé selon une des revendications 1 à 5,
**caractérisé en ce que**
la première couche (5) et/ou la deuxième couche (7) et/ou au moins une autre couche (9) déposée sur la deuxième couche (7) est ou sont tendue(s) mécaniquement par l'introduction d'atomes étrangers avant l'enlèvement de leurs régions qui débordent latéralement au-delà de la structure (4).

7. Procédé selon une des revendications 1 à 6,
**caractérisé en ce qu'**
on utilise la même matière pour la première couche (5) et pour la deuxième couche (7) et éventuellement pour au moins une autre couche (9) déposée sur la deuxième couche (7).

8. Procédé selon une des revendications 1 à 6,
**caractérisé en ce qu'**
on utilise des matières différentes pour les différentes couches (5, 7, 9).

9. Procédé selon une des revendications 1 à 8,
**caractérisé en ce qu'**
au moins une couche de métal noble est déposée pour constituer la couche extrême supérieure.
